# EUROPEAN PATENT SPECIFICATION

(11) **EP 1 895 495 B1**
(45) Date of publication and mention of the grant of the patent: **25.02.2009**
(21) Application number: 07104092.7
(22) Date of filing: 14.03.2007
(51) Int. Cl.: G09G 3/32

(54) **Organic electroluminescent display device and driving method for the same**
Organische elektrolumineszente Anzeigevorrichtung und Ansteuerverfahren dafür
Dispositif d'affichage électroluminescent organique et son procédé de commande

(30) Priority: 31.08.2006 KR 20060083758
(43) Date of publication of application: 05.03.2008
(73) Proprietor: Samsung Mobile Display Co., Ltd., Suwon-si Gyeonggi-do (KR)
(72) Inventor: Chung, Ji Seon Legal & IP Team, Yongin-si Gyeonggi-do (KR); Kim, Jin Hun Legal & IP Team, Yongin-si Gyeonggi-do (KR); Lee, Ji Yoon Legal & IP Team, Yongin-si Gyeonggi-do (KR)
(74) Representative: Hengelhaupt, Jürgen

(56) References cited:
- EP-A- 1 624 438
- US-A1- 2002 180 723
- US-A1- 2004 113 923
- US-A1- 2004 201 583
- US-A1- 2006 071 893

## Description

### BACKGROUND OF THE INVENTION

### 1. Field of the Invention

The technological field relates to an organic electroluminescence display device and a driving method for the same, and more particularly to an organic electroluminescence display device capable of reducing power consumption by displaying an image using colors associated with a small power consumption if a residual capacity of a battery is low when the residual capacity of the battery is measured, and driving method for the same.

### 2. Description of the Related Technology

A flat panel display is classified into a passive matrix type light emitting display and an active matrix type light emitting display, depending on driving systems of pixels. The active matrix type light emitting display, which selectively turns on the light in every unit pixel, has been widely used because of beneficial aspects of resolution, contrast, and response time.

The flat panel display has been used as displays or monitors of information appliances, such as personal computers, mobile phones, PDA, etc. a liquid crystal display (LCD) using a liquid crystal panel, an organic electroluminescence display device using an organic light emitting diode, and a plasma display panel (PDP) using a plasma panel and the like are widely known technologies for implementing flat panel displays.

In recent years, various light emitting displays have been developed which are more lightweight and have a smaller volume than a cathode ray tube, and in particular, an organic electroluminescence display device having excellent luminous efficiency, luminance and viewing angle and a rapid response time has shown promise.

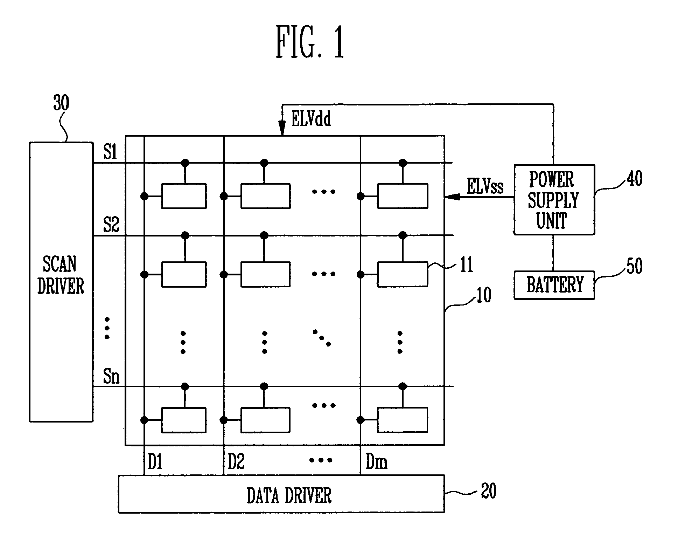

FIG. 1 is a schematic view showing a conventional organic electroluminescence display device. Referring to FIG. 1, the conventional organic electroluminescence display device includes a pixel unit 10, a data driver 20, a scan driver 30, a power supply unit 40 and a battery 50.

The pixel unit 10 has a plurality of pixels 11 arranged therein, and luminous elements (not shown) are connected to each of the pixels 11. The luminous elements are formed in a horizontal direction and formed in a vertical direction with n number of scan lines (S1,S2,...Sn-1,Sn) for transmitting a scan signal, and they have m number of data lines (D1, D2,....Dm-1, Dm) for transmitting a data signal; the m number of first power supply lines (not shown) transmitting a first power source; the m number of second power supply lines (not shown) transmitting a second power source (ELVss) having a lower electric potential than a first power source (ELVdd). The pixel unit 10 displays an image by allowing the luminous elements to emit the light by means of the scan signal, the data signal, the first power source (ELVdd) and the second power source (ELVss).

The data driver 20 is a unit for applying a data signal to the pixel unit 10, and connected to the data lines (D1, D2,....Dm-1, Dm) of the pixel unit 10 to apply the data signal to the pixel unit 10.

The scan driver 30 is a unit for sequentially outputting a scan signal and is connected to the scan lines (S1,S2,...Sn-1,Sn) to supply the scan signal to specific rows of the pixel unit 10. The data signal input in the data driver 20 is applied to each specific row of the pixel unit 10 to which the scan signal are supplied to display an image, and one frame is completed when all rows are sequentially selected.

The power supply unit 40 transmits a first power source (ELVdd) and a second power source (ELVss) to the pixel unit 10, the second power source (ELVss) having a lower electric potential than the first power source (ELVdd), and therefore an electric current corresponding to the data signal is allowed to flow in each of the pixels 11 because of a voltage difference of the first power source (ELVdd) and the second power source (ELVss).

The battery 50 is charged with a predetermined voltage to continuously drive an organic electroluminescence display device without receiving power from an outside power source. The voltage charged in the battery 50 is supplied to the power supply unit 40, converted into a voltage required for driving, and output from the power supply unit 40.

In the organic electroluminescence display device as configured above, the battery is recharged or not used until it is exchanged if all voltage charged in the battery is discharged. In particular, the organic electroluminescence display device may not be driven if spare batteries are not present or the used batteries are not recharged. Furthermore, US 2004/0201583 and US 2002/0180723 disclose methods for reducing power consumption of an organic electroluminescence display device depending on the residual capacity of the battery.

### SUMMARY OF CERTAIN INVENTIVE ASPECTS

Aspects of the present invention solve such drawbacks of the prior art, and provides an organic electroluminescence display device capable of extending a functioning period of the battery and, therefore, preventing the display driving from being stopped during its operation because power consumption is reduced by using colors having a low power consumption to display an image. A driving method for the same is also disclosed.

One embodiment is a organic electroluminescence display device including a pixel unit having pixels configured to emit red, green and blue light and to sequentially supply a data signal and a scan signal to each of the pixels to display an image, a data driver configured to supply the data signal to the pixel unit, a scan driver configured to supply the scan signal to the pixel unit, a battery, and a sensor configured to sense a residual charging capacity of the battery, where a voltage of the data signal output from the data driver is controlled by the sensor, depending on the residual charging capacity of the battery. That is, the organic electroluminescence display device comprises a means for determining a residual charging capacity of the battery and a means for selecting one voltage of a plurality of bias voltages depending on the residual capacity of the battery and for supplying the selected voltage to the data driver Both, the means for determining a residual charging capacity of the battery and the means for selecting the voltage can preferably be integrally formed by a single means.
The gray levels of the (red, green, blue sub-) pixels are set to 65% - 35% of the maximum gray level to be displayed if the residual charging capacity of the battery is less than 25% of the maximum capacity of the battery and the gray levels of the (red, green, blue sub-) pixels are set to 30% - 20% of the maximum gray level to be displayed if the residual charging capacity of the battery is less than 10% of the maximum capacity of the battery.
The pixel unit comprises a plurality of pixels, each pixel comprising a red sub-pixel adapted to emit red light, a green sub-pixel adapted green light and a blue sub-pixel adapted to blue light. Preferably, according to the present invention reddish light is also understood as red light, greenish light is also understood as green light and bluish light is also understood as blue light. Preferably the data driver comprises: a shift resistor configured to generated a sampling signal; a sampling latch configured to sample a digital data signal based on the sampling signal; a holding latch configured to hold the sampled digital data from the sampling latch and to output the held digital data; a level shifter configured to maintain the held digital data, from the holding latch, to a predetermined voltage, wherein the predetermined voltage is controlled by the signal output by the sensor; and a D/A converter (digital-analog converter) configured to convert the signal from the level shifter to an analog signal. Preferably the level shifter is directly connected with the sensor.
Preferably the pixel comprises: a first transistor; a second transistor configured to supply the data signal to a gate of the first transistor according to the scan signal; a capacitor configured to store a voltage of the gate in the first transistor for a predetermined period; and an organic light emitting diode configured to receive the driving electric current to emit light.
Preferably the pixel unit is supplied with electric power only by a power supply unit, that is, there is preferably no other power supply for the pixel unit. Furthermore, preferably the power supply unit is supplied with electric power only by the battery, that is, there is preferably no other power supply for the power supply unit than the battery. Preferably the pixel unit, the data driver, the scan driver and the sensor are configured to be driven only by the power which is supplied by the battery without any external power sources.

Another embodiment is a organic electroluminescence display device including a pixel unit having pixels configured to emit red, green and blue light and to supply a data signal and a scan signal to each of the pixels to display an image, a data driver configured to supply the data signal to the pixel unit, a scan driver configured to supply the scan signal to the pixel unit, a battery, and a sensor configured to sense whether or not the driving power source of the pixel unit is received from the battery, where a voltage of the data signal output from the data driver is controlled by the sensor, depending on whether or not the driving power of the pixel unit is received from the battery.
Preferably the data driver is configured to set the voltage of the data signal to a lower level than a reference value if the power of the pixel unit is received from the battery. Preferably the red pixels are configured to display one color of maroon and dark red if the voltage of the data signal is set to a lower level than the reference value. Preferably the blue pixels are configured to display one color of navy blue and dark blue if the voltage of the data signal is set to a lower level than the reference value. Preferably the sensor is configured to generate a plurality of bias voltages, and one voltage of the plurality of the bias voltages is selected according to whether or not the driving power of the pixel unit is received from the battery. Preferably a voltage of the data signal supplied to at least one pixel of the red, green and blue pixels is supplied in a low level if the residual capacity of the battery is less than a predetermined value.

Another embodiment is a method of driving an organic electroluminescence display device which receives power from a battery and uses red, green and blue pixels to display an image. The method includes determining a residual capacity of the battery, and controlling a voltage of a data signal if the residual capacity of the battery is less than a predetermined value.
A voltage of the data signal supplied to at least one pixel of the red, green and blue pixels is supplied in a reduced level if the residual capacity of the battery is less than a predetermined value. The red pixels display one color of maroon and dark red colors if the residual capacity of the battery is less than a predetermined value. The blue pixels display one color of navy blue and dark blue colors if the residual capacity of the battery is less than a predetermined value.

Another embodiment is a method of driving an organic electroluminescence display device which receives power from a battery or another power source and uses red, green and blue pixels to display an image. The method includes receiving the power from the battery, and adjusting a voltage of a data signal to a lower level if the voltage of the data signal is connected to the other power source.
The voltage of the data signal supplied to at least one pixel of the red, green and blue pixels is supplied in a reduced level.

### BRIEF DESCRIPTION OF THE DRAWINGS

These and/or other aspects and advantages of the invention will become apparent and more readily appreciated from the following description of certain embodiments, taken in conjunction with the accompanying drawings of which:

FIG. 1 is a schematic view showing a conventional organic electroluminescence display device.

FIG. 2 is a schematic view showing an organic electroluminescence display device.

FIG. 3 is a circuit view showing a configuration of pixels used in the organic electroluminescence display device as shown in FIG. 2.

FIG. 4A to FIG. 4C are diagrams showing a difference of power consumption depending on colors.

FIG. 5 is a schematic view showing a data driver used in the organic electroluminescence display device as shown in FIG. 2.

### DETAILED DESCRIPTION OF CERTAIN INVENTIVE EMBODIMENTS

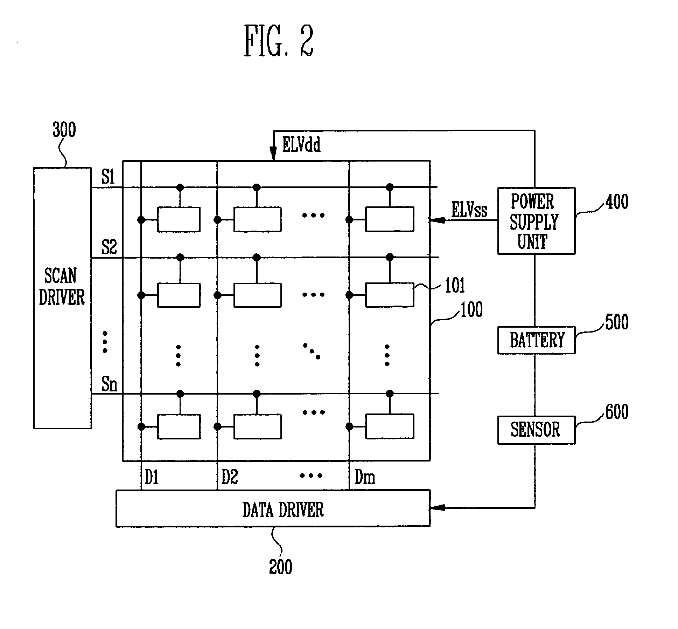

FIG. 2 is a schematic view showing an organic electroluminescence display device. Referring to FIG. 2, the organic electroluminescence display device includes a pixel unit 100, a data driver 200, a scan driver 300, a power supply unit 400, a battery 500 and a sensor 600.

The pixel unit 100 includes a plurality of pixels 101 electrically connected to the n number of scan lines (S1,S2,...,Sn) arranged in a horizontal direction, and the m number of data lines (D1,D2,...Dm) arranged in a vertical direction, and each of the pixels 101 receives a first power source (ELVdd) and a second power source (ELVss). Also, a plurality of the pixels 101 include unit pixels for displaying reddish, greenish, or bluish colors, and display a grey level, depending on a voltage of the data signal.

The data driver 200 is connected to a plurality of the data lines (D1,D2,...Dm), and receives an image signal to generate a data signal and supplies the generated data signal to the pixel unit 100 through the data lines (D1,D2,...Dm).

The data signal output from the data driver 200 has a value controlled to correspond to a capacity of the battery. If the capacity stored in the battery is large, then the data signal has a high voltage, and if the capacity stored in the battery is small, then the data signal has a low voltage. If the voltage of the data signal is small, then power consumption is lowered due to the low voltage of the data signal. As a result, the period of using electricity charged in the battery may be extended. In some embodiments, lowering a voltage of the data signal is accomplished by using a voltage resulting in 128 grey levels is output, even if a data signal exhibiting 255 grey levels is input, where brightness of the colors is sacrificed.

The scan driver 300 is connected to the scan lines (S1,S2,...Sn), and supplies a scan signal to the pixel unit 100 through the scan lines. The scan signal is sequentially generated, and each row of the pixel unit 100 is sequentially selected by the scan signal, and then the data signal is supplied to the selected rows.

The power supply unit 400 supplies a first power source (ELVdd) and second power source (ELVss) to the pixel unit 10, the second power source (ELVss) having a lower electric potential than the first power source (ELVdd), thereby to allow an electric current, corresponding to the data signal, to flow in each of the pixels 101 because of a voltage difference between the first power source (ELVdd) and the second power source (ELVss).

The battery 500 is charged with a predetermined voltage so that the organic electroluminescence display device can be continuously operated without receiving a power source from the outside. And, the voltage charged in the battery 500 is supplied to the power supply unit 400, converted into a voltage required for driving, and output from the power supply unit 400.

The sensor 600 senses a connection relation to a battery 500, or senses the charged voltage of the battery, and then adjusts a voltage of the data signal output from the data driver 200 to correspond to the charged voltage. If the organic electroluminescence display is driven using the battery 500, then a functional period of the battery is determined according to a charged capacity. Therefore, the battery 500 may not be used for an extended period if it has a high power consumption. If the capacity charged in the battery 500 is small, then the functional period of the battery is particularly short. Accordingly, if the organic electroluminescence display is driven using the battery 500 (instead of another power source), or if an electric capacity charged in the battery 500 is low, then a voltage of the data signal may be lowered to display an image having a low grey-scale level, and therefore a functional period of the battery 500 may be extended. The sensor 600 uses bias voltages, supplied to the data driver 300, to adjust a voltage of the data signal. The sensor 600 outputs one voltage of a plurality of the bias voltages if a plurality of the bias voltages are connected to the battery 500 when the sensor 600 senses whether or not a plurality of the bias voltages are connected to the battery 500, or if a residual capacity charged in the battery 500 is low when the sensor 600 senses the charged residual capacity.

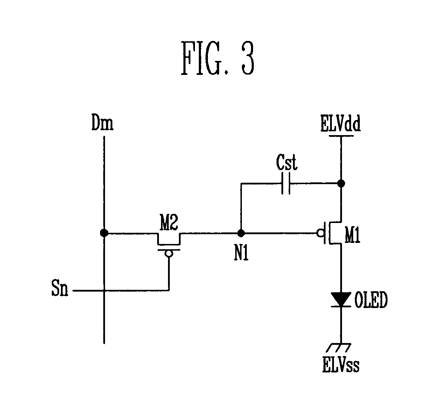

FIG. 3 is a circuit view showing a configuration for pixels used in the organic electroluminescence display device as shown in FIG. 2. Referring to FIG. 3, the pixels 101 include a first transistor (M1), a second transistor (M2), a capacitor (Cst) and an organic light emitting diode (OLED).

The first transistor (M1) has a source connected to the first power source; a drain connected to the organic light emitting diode (OLED); and a gate connected to a first node (N1), and it controls an electric current that flows in a direction from the source to the drain to correspond to a voltage of the first node (N1).

The second transistor (M2) has a source connected to the data lines (Dm); a drain connected to the first node (N1); and a gate connected to the scan lines (Sn), and supplies the data signal, supplied through the data lines, to the first node (N1) to correspond to the scan signal supplied through the scan lines (Sn).

The capacitor (Cst) has a first electrode connected to the first power source (ELVdd); and a second electrode connected to the first node (N1). The voltage stored in the capacitor (Cst) is used to maintain a voltage of the data signal supplied to the first node (N1) if the second transistor (M2) is in a turned-off state and the data signal is not supplied to the first node (N1).

The organic light emitting diode (OLED) has an emission layer between an anode and a cathode. The emission layer emits light as an electric current flows through it. Accordingly, the organic light emitting diode (OLED) has an anode connected to a drain of the first transistor (M1); and a cathode connected to the second power source (ELVss), and therefore the organic light emitting diode (OLED) emits the light since an electric current flows in a direction from an anode to a cathode if an electric current flows in a direction from the source to the drain of the first transistor (M1).

In the pixels of the organic electroluminescence display device as configured above, power consumption is increased if a large electric current flows to emission elements, and power consumption is decreased if the electric current is small. That is to say, if a grey-scale level voltage is high, then the electric current flowing to the organic light emitting diode is high and the power consumption is high. Conversely, the power consumption is lower if the grey-scale level voltage is lower. Another embodiment is a high grey-scale level of voltage can be input when the organic light emitting diode (OLED) emits red, green and blue light, and particularly the highest grey-scale level voltage can be input when the organic light emitting diode (OLED) emits the red and blue light. In order to reduce power consumption, a grey-scale color having a lower level than the red, green and blue colors may be used to display an image.

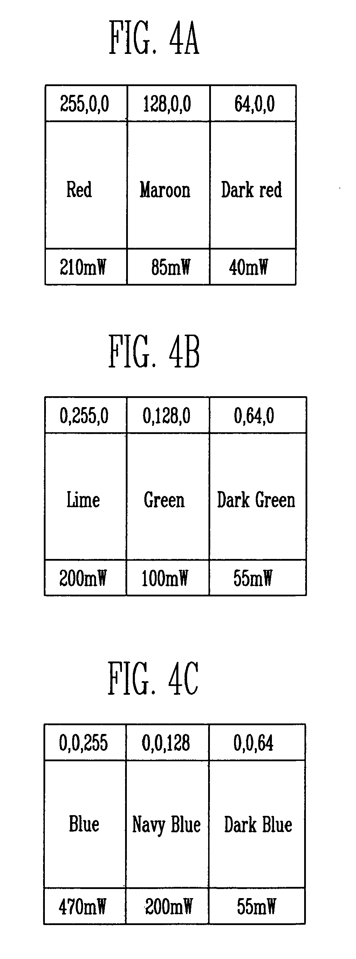

FIGs. 4A to FIG. 4C are diagrams showing a difference of power consumption depending on colors. FIG. 4A is a diagram showing a difference of power consumption of reddish colors, FIG. 4B is a diagram showing a difference of power consumption of greenish colors, and FIG. 4C is a diagram showing a difference of power consumption of bluish colors.

Referring to FIG. 4A, the red pixel displays a red color if the maximum 255 grey level voltage is input, and a power consumption is 210 mw if the red pixel displays a red color. The red pixel displays a maroon color if a 128 grey level voltage is input, and a power consumption is 85 mw if the red pixel displays a maroon color. And, the red pixel displays a dark red color if a 64 grey level voltage is input, and a power consumption is 40 mw if the red pixel displays a dark red color.

Referring to FIG. 4B, the green pixel displays a lime color if the maximum 255 grey level voltage is input, a power consumption is 200 mw if the green pixel displays a lime color. The green pixel displays a green color if a 128 grey level voltage is input, and a power consumption is 100 mw if the green pixel displays a green color. And, the green pixel displays a dark green color if a 64 grey level voltage is input, and a power consumption is 55 mw if the green pixel displays a dark green color.

Referring to FIG. 4C, the blue pixel displays a blue color if the maximum 255 grey level voltage is input, a power consumption is 470 mw if the blue pixel displays a blue color. The blue pixel displays a navy blue color if a 128 grey level voltage is input, and a power consumption is 200 mw if the blue pixel displays a navy blue color. And, the blue pixel displays a dark blue color if a 64 grey level voltage is input, and a power consumption is 55 mw if the blue pixel displays a dark blue color.

As shown in FIGs. 4A to FIG. 4C, the voltage of the data signal may be varied to display an image only with the red and blue pixels since the green pixel has a lower power consumption than those of the red and blue pixels.

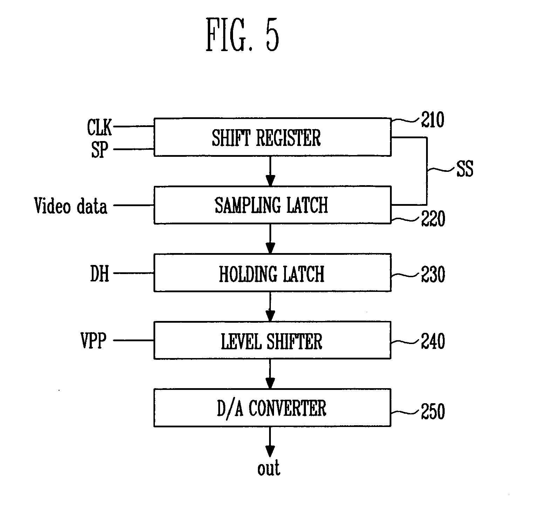

FIG. 5 is a schematic view showing a data driver used in the organic electroluminescence display device as shown in FIG. 2. Referring to FIG. 5, the data driver 200 includes a shift resistor 210, a sampling latch 220, a holding latch 230, a level shifter 240 and a D/A converter 250.

The shift resistor 210 sequentially shifts start pulses (SP) depending on a clock signal (CLK) to generate a sampling signal, to supply the generated sampling signal to the sampling latch 220.

The sampling latch 220 receives the sampling signal output from the shift resistor 210, and then stores a digital data signal input in series.

The holding latch 230 receives the digital signal stored in the sampling latch 220, according to a holding signal (DH) supplied from the outside, holds the received digital signal during a first horizontal period, and then outputs the digital signal.

The level shifter 240 receives a bias voltage from the outside, and then outputs the received bias voltage to a D/A converter 250. A voltage of the bias voltage supplied from the outside is received from the sensor 600 as shown in FIG. 2. The sensor 600 selects one voltage of a plurality of the bias voltages and outputs the selected voltage to correspond to the residual capacity of the battery 500. Accordingly, the bias voltages for each color can be adjusted to correspond to the residual capacity of the battery 600.

The D/A converter 250 is configured to convert the digital signal into an analog signal. The bias voltage output from the level shifter 240 is used to convert an output value of the level shifter 240 into an analog signal to supply the converted analog signal to the data lines.

As described above, the organic electroluminescence display device and the driving method for the same may be useful to reduce power consumption by using colors having a lower power consumption than those of red, blue and green colors to display an image having various colors, and particularly to prevent its driving from being stopped during its operation by displaying an image with colors having a low power consumption if a residual capacity of the battery is low.

The description proposed herein are for the purpose of illustrations only, and are not intended to limit the scope of the invention. It should be understood that other equivalents and modifications could be made without departing from the scope of the invention as apparent to those skilled in the art.

## Claims

1. An organic electroluminescence display device adapted to display grey scale voltages corresponding to a range between a maximum luminance voltage and a minimum luminance voltage, comprising:
a pixel unit (100) including a plurality of pixels (101), each pixel (101) comprising a red sub-pixel configured to emit red light, a green sub-pixel configured to emit green light and a blue sub-pixel configured to emit blue light, the pixel unit (100) being adapted to sequentially supply a data signal and a scan signal to each of the pixels (101) to display an image;
a data driver (200) configured to supply the data signal to the pixel unit (100);
a scan driver (300) configured to supply the scan signal to the pixel unit (100);
a battery (500) adapted to supply power for the pixel unit (100); and
a sensor (600) configured to sense a residual charging capacity of the battery (500), **characterised in that** the sensor is further configured to select one voltage of a plurality of bias voltages depending on the residual capacity of the battery (500) and to supply the selected voltage to the data driver (200);
wherein the voltages of the data signal corresponding to the gray levels of the red and blue sub-pixels are scaled, according to the said selected voltage, to be within the range 65% to 35% of the said maximum luminance voltage if the residual charging capacity of the battery is less than 25% of the maximum capacity of the battery, and
wherein the voltages of the data signal corresponding to the gray levels of the red and blue sub-pixels are scaled, according to the said selected voltage, to be within the range 30% to 20% of the said maximum luminance voltage if the residual charging capacity of the battery is less than 10% of the maximum capacity of the battery.

2. The organic electroluminescence display device according to one of the preceding claims, wherein the data driver (200) comprises:
a shift register (210) configured to generated a sampling signal;
a sampling latch (220) configured to sample a digital data signal based on the sampling signal;
a holding latch (230) configured to hold the sampled digital data from the sampling latch (220) and to output the held digital data;
a level shifter (240) configured to maintain the held digital data, from the holding latch (230), to a predetermined voltage, wherein the predetermined voltage is controlled by the selected one signal of the bias voltage signals output by the sensor (600); and
a D/A converter (250) configured to convert the signal from the level shifter (240) to an analog signal.

3. The organic electroluminescence display device according one of the preceding claims, wherein a sub-pixel comprises:
a first transistor (M1);
a second transistor (M2) configured to supply the data signal to a gate of the first transistor (M1) according to the scan signal;
a capacitor (Cst) configured to store a voltage of the gate in the first transistor (M1) for a predetermined period; and
an organic light emitting diode (OLED) configured to receive the driving electric current to emit light.

4. A method of driving an organic electroluminescence display device according to one of the claims 1-3, the method comprising:
determining a residual capacity of the battery (500); and **characterised by**
controlling a voltage of the data signal if the residual capacity of the battery (500) is less than a predetermined value,
wherein the voltage of the data signal corresponding to the gray levels of the red and blue sub-pixels are scaled, according to the said selected voltage, to be whithin the range 65% to 35% of the said maximum luminance voltage if the residual charging capacity of the battery is less than 25% of the maximum capacity of the battery, and
wherein the voltage of the data signal corresponding to the gray levels of the red and blue sub-pixels are scaled, according to the said selected voltage, to be within the range 30% to 20% of the said maximum luminance voltage if the residual charging capacity of the battery is less than 10% of the maximum capacity of the battery.

## Patentansprüche

1. Organische elektrolumineszente Anzeigevorrichtung, die ausgebildet ist, Graustufenspannungen anzuzeigen, die einem Bereich zwischen einer maximalen Leuchtdichte-Spannung und einer minimalen Leuchtdichte-Spannung entsprechen, wobei die organische elektrolumineszente Anzeigevorrichtung aufweist:
eine Pixeleinheit (100), die eine Vielzahl von Pixeln (101) aufweist, wobei jeder Pixel (101) einen roten Subpixel, der zur Emission von rotem Licht ausgebildet ist, einen grünen Subpixel, der zur Emission von grünem Licht ausgebildet ist, und einen blauen Subpixel, der zur Emission von blauem Licht ausgebildet ist, aufweist, und wobei die Pixeleinheit (100) ausgebildet ist, jeden der Pixel (101) nacheinander mit einem Datensignal und einem Ansteuersignal zu versorgen, um ein Bild anzuzeigen;
einen Datentreiber (200), der zur Versorgung der Pixeleinheit (100) mit dem Datensignal ausgebildet ist;
einen Ansteuertreiber (300), der zur Versorgung der Pixeleinheit (100) mit dem Ansteuersignal ausgebildet ist;
eine Batterie (500), die zur Versorgung der Pixeleinheit (100) mit Energie ausgebildet ist; und
einen Sensor (600), der zur Erkennung einer Restladekapazität der Batterie (500) ausgebildet ist,
**dadurch gekennzeichnet, dass** der Sensor weiterhin ausgebildet ist, in Abhängigkeit von der Restkapazität der Batterie (500) eine Spannung aus der Vielzahl von Vorspannungen zu selektieren und den Datentreiber (200) mit der selektierten Spannung zu versorgen;
wobei die den Graustufen der roten und blauen Subpixel entsprechenden Spannungen des Datensignals gemäß der besagten selektierten Spannung derart skaliert werden, dass sie im Bereich zwischen 65% und 35% der besagten maximalen Leuchtdichte-Spannung liegen, wenn die Restladekapazität der Batterie weniger als 25% der maximalen Kapazität der Batterie beträgt, und
wobei die den Graustufen der roten und blauen Subpixel entsprechenden Spannungen des Datensignals gemäß der besagten selektierten Spannung derart skaliert werden, dass sie im Bereich zwischen 30% und 20% der besagten maximalen Leuchtdichte-Spannung liegen, wenn die Restladekapazität der Batterie weniger als 10% der maximalen Kapazität der Batterie beträgt.

2. Organische elektrolumineszente Anzeigevorrichtung nach einem der vorhergehenden Ansprüche, wobei der Datentreiber (200) aufweist:
ein Schieberegister (210), das zur Erzeugung eines Abtastsignals ausgebildet ist;
einen Abtastspeicher (220), der zur Abtastung eines auf dem Abtastsignal basierenden Datensignals ausgebildet ist;
einen Haltespeicher (230), der zum Halten der abgetasteten digitalen Daten vom Abtastspeicher (220) sowie zur Ausgabe der gehaltenen digitalen Daten ausgebildet ist;
einen Pegelschieber (240), der ausgebildet ist, die gehaltenen digitalen Daten vom Haltespeicher (230) bei einer vorbestimmten Spannung aufrechtzuerhalten, wobei die vorbestimmte Spannung durch das vom Sensor (600) ausgegebene selektierte eine Signal der Vorspannungssignale geregelt wird; und
einen Digital-Analog-Wandler (250), der ausgebildet ist, das Signal vom Pegelschieber (240) in ein analoges Signal umzuwandeln.

3. Organische elektrolumineszente Anzeigevorrichtung nach einem der vorhergehenden Ansprüche, wobei ein Subpixel aufweist:
einen ersten Transistor (M1),
einen zweiten Transistor (M2), der ausgebildet ist, ein Gate des ersten Transistors (M1) gemäß dem Ansteuersignal mit dem Datensignal zu versorgen;
einen Kondensator (Cst), der ausgebildet ist, eine Spannung des Gates während eines vorbestimmten Zeitintervalls im ersten Transistor (M1) zu speichern; und
eine organische Leuchtdiode (OLED), die ausgebildet ist, den Ansteuerstrom zu erhalten, um Licht zu emittieren.

4. Verfahren zur Ansteuerung einer organischen elektrolumineszenten Ansteuervorrichtung nach einem der Ansprüche 1-3, wobei das Verfahren aufweist:
Bestimmung einer Restkapazität der Batterie (500); und **gekennzeichnet durch**
die Regelung einer Spannung des Datensignals, wenn die Restkapazität der Batterie (500) kleiner als ein vorbestimmter Wert ist,
wobei die den Graustufen der roten und blauen Subpixel entsprechenden Spannungen des Datensignals gemäß der besagten selektierten Spannung derart skaliert werden, dass sie im Bereich zwischen 65% und 35% der besagten maximalen Leuchtdichte-Spannung liegen, wenn die Restladekapazität der Batterie weniger als 25% der maximalen Kapazität der Batterie beträgt, und
wobei die den Graustufen der roten und blauen Subpixel entsprechenden Spannungen des Datensignals gemäß der besagten selektierten Spannung derart skaliert werden, dass sie im Bereich zwischen 30% und 20% der besagten maximalen Leuchtdichte-Spannung liegen, wenn die Restladekapazität der Batterie weniger als 10% de maximalen Kapazität der Batterie beträgt.

## Revendications

1. Dispositif d'affichage organique à électroluminescence conçu pour afficher des tensions d'échelle de gris correspondant à une plage entre une tension de luminance maximale et une tension de luminance minimale, comportant :
une unité de pixels (100) comprenant de multiples pixels (101), chaque pixel (101) comprenant un sous-pixel rouge configuré pour émettre de la lumière rouge, un sous-pixel vert configuré pour émettre de la lumière verte et un sous-pixel bleu configuré pour émettre de la lumière bleue, l'unité de pixels (100) étant conçue pour fournir séquentiellement un signal de données et un signal de balayage à chacun des pixels (101) afin d'afficher une image ;
un circuit d'attaque (200) de données configuré pour fournir le signal de données à l'unité de pixels (100) ;
un circuit d'attaque (300) de balayage configuré pour fournir le signal de balayage à l'unité de pixels (100) ;
une batterie (500) configurée pour alimenter en énergie l'unité de pixels (100) ; et
un capteur (600) configuré pour capter une capacité de charge résiduelle de la batterie (500), **caractérisé en ce que** le capteur est configuré en outre pour sélectionner une tension parmi une pluralité de tensions de polarisation suivant la capacité résiduelle de la batterie (500) et pour fournir la tension sélectionnée au circuit (200) d'attaque de données ;
dans lequel les tensions du signal de données correspondant aux niveaux de gris des sous-pixels rouges et bleus sont mises à l'échelle, conformément à ladite tension sélectionnée, afin d'être comprises dans la plage de 65 % à 35 % de ladite tension de luminance maximale si la capacité de charge résiduelle de la batterie est inférieure à 25 % de la capacité maximale de la batterie, et
dans lequel les tensions du signal de données correspondant aux niveaux de gris des sous-pixels rouges et bleus sont mises à l'échelle, conformément à ladite tension sélectionnée, afin d'être comprises dans la plage de 30 % à 20 % de ladite tension de luminance maximale si la capacité de charge résiduelle de la batterie est inférieure à 10 % de la capacité maximale de la batterie.

2. Dispositif d'affichage organique à électroluminescence selon l'une des revendications précédentes, dans lequel le circuit (200) d'attaque de données comporté :
un registre à décalage (210) configuré pour générer un signal d'échantillonnage ;
une bascule (220) d'échantillonnage configurée pour échantillonner un signal de données numériques basé sur le signal d'échantillonnage ;
une bascule de blocage (230) configurée pour bloquer les données numériques échantillonnées provenant de la bascule d'échantillonnage (220) et pour délivrer en sortie les données numériques bloquées ;
une unité (240) de décalage de niveau configurée pour maintenir les données numériques bloquées, provenant de la bascule de blocage (230), à une tension prédéterminée, la tension prédéterminée étant commandée par le signal sélectionné parmi les signaux de tension de polarisation délivrés en sortie par le capteur (600) ; et
un convertisseur N/A (250) configuré pour convertir le signal provenant de l'unité (240) de décalage de niveau en un signal analogique.

3. Dispositif d'affichage organique à électroluminescence selon l'une des revendications précédentes, dans lequel un sous-pixel comprend :
un premier transistor (M1) ;
un second transistor (M2) configuré pour fournir le signal de données à une grille du premier transistor (M1) conformément au signal de balayage ;
un condensateur (Cst) configuré pour stocker une tension de la grille dans le premier transistor (M1) pendant une période prédéterminée ; et
une diode organique d'émission de lumière (OLED) configurée pour recevoir le courant électrique d'attaque afin d'émettre de la lumière.

4. Dispositif d'affichage organique à électroluminescence selon l'une des revendications 1 à 3, le procédé comprenant :
la détermination d'une capacité résiduelle de la batterie (500) ; et **caractérisé par**
la commande d'une tension du signal de données si la capacité résiduelle de la batterie (500) est inférieure à une valeur prédéterminée,
dans lequel la tension du signal de données correspondant aux niveaux de gris des sous-pixels rouges et bleus est mise à l'échelle, conformément à ladite tension sélectionnée, afin d'être comprise dans la plage de 65 % à 35 % de ladite tension de luminance maximale si la capacité de charge résiduelle de la batterie est inférieure à 25 % de la capacité maximale de la batterie, et
dans lequel la tension du signal de données correspondant aux niveaux de gris des sous-pixels rouges et bleus est mise à l'échelle, conformément à ladite tension sélectionnée, afin d'être comprise dans la plage de 30 % à 20 % de ladite tension de luminance maximale si la capacité de charge résiduelle de la batterie est inférieure à 10 % de la capacité maximale de la batterie.
